# EUROPÄISCHE PATENTANMELDUNG

(11) **EP 2 802 017 A1**
(43) Veröffentlichungstag der Anmeldung: **12.11.2014**
(21) Anmeldenummer: 13167080.4
(22) Anmeldetag: 08.05.2013
(51) Int. Cl.: H01L 31/05, H01L 31/18

(54) **Solarzellen-String, Verfahren und Vorrichtung zum Verbinden von Solarzellen zu einem Solarzellen-String**

(71) Anmelder: Komax Holding AG, 6036 Dierikon (CH)
(72) Erfinder: Kaufmann, Stefan, 5000 Aarau (CH); Hofer, Adolf, 8426 Lufingen (CH)
(74) Vertreter: Blöchle, Hans

(57) **Zusammenfassung**

Ein Solarzellen-String mit aneinander gereihten Solarzellen (2) umfasst Kontaktelemente (3) zum elektrischen Verbinden der Solarzellen, die durch Tiefziehen oder Prägen geschaffene napfartige Vertiefungen (6) aufweisen, die durch Öffnungen (5) in den Isolationsbändem (4) die Solarzellen (2) kontaktieren.

## Beschreibung

Die Erfindung betrifft einen Solarzellen-String, ein Verfahren und eine Vorrichtung zum Verbinden von Solarzellen zu einem Solarzellen-String. Die Erfindung eignet sich insbesondere zum Verbinden von sogenannten Rückseiten-Solarzellen, die sich dadurch auszeichnen, dass die Kontaktzonen, d.h. die p-dotierten und n-dotierten Bereiche, auf derselben Seite der Solarzelle befinden.

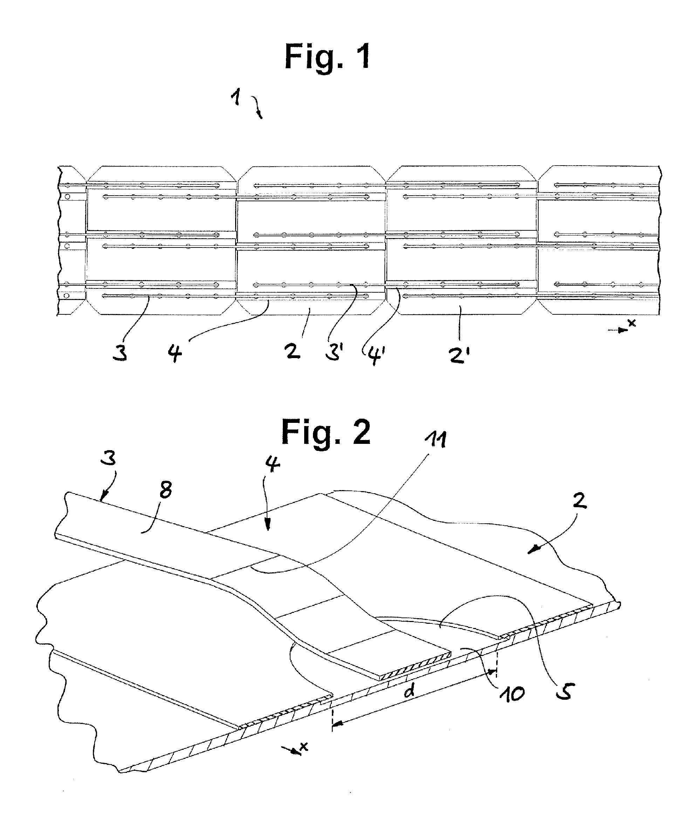

Figur 1 zeigt einen gattungsmässig vergleichbaren Solarzellen-String nach dem Stand der Technik. Details zum Aufbau und Ausgestaltung der Verbindungsanordnung des bekannten Solarzellen-Strings sind aus Figur 2 entnehmbar, die einen String aus Rückseiten-Solarzellen betrifft. Zum elektrischen Verbinden der Solarzellen wird ein durch Biegeumformen geschaffenes Kupferband verwendet. Auf der Rückseite der Solarzelle ist ein sich in x-Richtung erstreckendes Isolationsband 4 angeordnet, das Öffnungen 5 aufweist, wobei die Öffnungen n-dotierte Kontaktzonen 10 freigeben. Die Zone 10 ist dem Fachmann auch unter dem englischen Begriff "n-Pad" geläufig. Das Kontaktelement 3 ist als Biegeteil ausgestaltet und weist Biegekanten auf, die durch die quer zur x-Richtung verlaufenden parallelen Linien 11 angedeutet sind. Die bekannten Kontaktelemente sind vergleichsweise schmal; die maximale Breite des Kontaktelements 3 ist durch den Öffnungsdurchmesser d beschränkt. Derart schmale Kontaktelemente führen wegen des relativ hohen ohmschen Widerstandes zu einem unerwünschten Leistungsverlust.

Es ist daher die Aufgabe der Erfindung, ein Solarzellen-String der eingangs erwähnten Art zu schaffen, welcher energetisch effizienter betrieben werden kann. Insbesondere sollen sich die Verbindungen der Solarzellen durch geringe ohmsche Verluste auszeichnen. Der Wirkungsgrad eines aus einem oder mehreren derartiger Solarzellen-Strings aufgebauten Solarmoduls soll optimiert werden.

Diese Aufgabe wird erfindungsgemäss mit einem Solarzellen-String mit den Merkmalen des Anspruches 1 gelöst. Mehrere entlang einer Längsrichtung aneinandergereihte Solarzellen werden vorzugsweise jeweils aus einem Metallband (z.B. aus Kupfer) gebildete Kontaktelemente elektrisch verbunden. Ein solches Kontaktelement verbindet jeweils zwei benachbarte Solarzellen miteinander. Wenigstens für die Kontaktbereiche mit den n-Polen bzw. für die n-dotierten Zonen sind die Solarzellen mit einem Isolationsmaterial versehen, das jeweils wenigstens eine Öffnung aufweist, über die das Kontaktelement die Solarzellen kontaktiert. Das Isolationsmaterial kann ein sich in Längsrichtung erstreckendes Band sein. Für die Isolation kann zum Beispiel ein vorzugsweise einseitig klebendes Isolationsband verwendet werden, das beispielsweise aus einem elektrisch nicht oder nur schwach leitfähigen Kunststoffmaterial besteht. Ein derartiges Klebeband kann durch Andrücken auf die Solarzellenoberfläche an die Solarzelle einfach fixiert werden. Selbstverständlich wären aber auch andere Möglichkeiten zum Aufbringen von Isolationsbändern auf die Solarzellen denkbar. Als Isolationsmaterial kommt beispielhaft auch Lötstopplack in Frage, der mittels Siebdruck auf die Solarzelle aufgebracht wird. Anstatt beispielsweise eines oder mehrerer Isolationsbänder könnte die Solarzelle demnach mit etwa gleich dimensionierten Streifen aus Lötstopplack versehen sein. Isolationsmaterial könnte aber auch in einem anderen Beschichtungsverfahren oder auf andere Weise auf die Solarzellen aufgebracht werden. Wenn die Solarzellen mehrere Reihen von n-Polen aufweisen, dann können die Solarzellen bevorzugt mit einer entsprechenden Anzahl von darauf aufgebrachten Isolationsbändern versehen sein. Dadurch, dass zum Erstellen des Kontakts zwischen Kontaktelement und Solarzelle das Kontakt eine in der wenigstens einen Öffnung aufgenommene Vertiefung aufweist, ergeben sich mehrere Vorteile. Dank der mit Vertiefungen versehenen Kontaktelemente können breitere Kontaktelemente verwendet werden, wodurch die Übertragungsleistung in Folge reduziertem ohmschen Verlust erheblich erhöht werden kann. So kann der Wirkungsgrad eines Solarmoduls aufgebaut aus derartigen Solarzellen-Strings verbessert werden. Je nach Ausgestaltung der Vertiefung lässt sich schliesslich ein verbesserter Kontakt zwischen Kontaktelement und Solarzelle erreichen.

Wenn das Kontaktelement beispielsweise ein Metallband ist, kann es vorteilhaft sein, wenn die Vertiefung eine vorzugsweise durch ein Tiefzieh- oder Prägevorgang im Metallband geschaffene, napfartige Vertiefung ist. Derartige napfartige Vertiefungen lassen sich einfach herstellen.

Zum Schaffen einer vorteilhaften Kontaktfläche zur Oberfläche der Solarzelle kann die Vertiefung einen planen Napfboden aufweisen.

Die Öffnung und/oder die der Öffnung zugeordnete Vertiefung können in Bezug auf eine Draufsicht kreisförmig ausgestaltet sein. Beispielsweise einer Öffnung eines Kreislochs ist besonders bevorzugt eine etwa komplementäre, kreisförmige Vertiefung zugeordnet. Selbstverständlich wären aber auch andere Öffnungsformen und Vertiefungsformen denkbar. Die Öffnung könnte beispielsweise oval ausgebildet sein. In Frage kommen aber auch polygonale Öffnungsformen und Vertiefungsformen. Besonders vorteilhaft sind die Öffnung und Vertiefung gleichartig geformt, wobei in der Regel die Vertiefung kleiner als die Öffnung sein sollte. Solange die Vertiefung in die Öffnung passt, wären sogar auch verschiedenartige Formgebungen vorstellbar.

Wenn das Kontaktelement in Bezug auf die Draufsicht jeweils die wenigstens eine Öffnung allseitig überlappt, d.h. wenn das jeweilige Kontaktelement in einer Draufsicht breiter als die Öffnung ist, ergibt sich ein energetisch besonders effizienter Solarzellen-String.

Die Anordnung lässt sich weiter optimieren, wenn das Kontaktelement jeweils gegenüber dem Durchmesser der wenigstens eine Öffnung mindestens 25%, bevorzugt mindestens 50% und besonders bevorzugt etwa 100% breiter ist. Für bestimmte Anwendungsgebiete könnten die Solarzellen des Solarzellen-Strings sogar mit noch breiteren Kontaktelementen bestückt werden.

Für mechanisch stabile Verbindungen kann das jeweilige Kontaktelement jeweils im Bereich einer Vertiefung wenigstens einen Flächenabschnitt aufweisen, der auf dem Isolationsmaterial liegt. Die Vertiefung ist gegenüber dem erwähnten Flächenabschnitt erhaben. Die Tiefe der Vertiefung würde damit der Dicke des Isolationsmaterials entsprechen. Theoretisch wäre es aber auch vorstellbar, tiefere Vertiefungen (Tiefe der Vertiefung ist grösser als die Dicke des Isolationsmaterials) vorzusehen, wodurch ein Abstand bzw. Luftspalt zwischen Solarzellenoberfläche und Flächenabschnitt des Isolationsmaterials sich ergibt.

Das jeweilige Kontaktelement kann wenigstens zwei Flächenabschnitte aufweisen, die über einen freiliegenden, von der Solarzelle beabstandeten Brückenabschnitt verbunden sind. Das Kontaktelement weist dabei entsprechend bevorzugt zwei gegenüber den Flächenabschnitten erhabene Vertiefungen auf.

Ein weiterer Aspekt der Erfindung betrifft ein Verfahren zum Verbinden von Solarzellen und insbesondere zum Verbinden von Rückseiten-Solarzellen zu einem Solarzellen-String, insbesondere dem vorgängig beschriebenen Solarzellenstring. Das Verfahren umfasst folgende Arbeitsschritte: Wenigstens bereichsweise wird mit Öffnungen versehenes, vorfabriziertes Isolationsmaterial in Form eines Isolationsbandes auf die Solarzellen aufgebracht. Beispielsweise werden hierfür mit Öffnungen versehene Isolationsbänder verwendet. Diese Isolationsbänder werden jeweils derart auf die Solarzellen platziert, dass die Öffnungen die n-Kontaktzonen freigeben. In einem nächsten Schritt werden die Kontaktelemente hergestellt, indem in Metallbänder Vertiefungen durch einen Tiefzieh- oder Prägevorgang eingebracht werden. Danach können die Solarzellen mit den derart hergestellten Kontaktelementen bestückt werden, wobei beim Bestückungsvorgang die Vertiefungen in die jeweiligen Öffnungen eingesetzt werden.

Ein weiterer Aspekt der Erfindung betrifft schliesslich eine Vorrichtung zum elektrischen Verbinden von Solarzellen mittels Kontaktelementen vorzugsweise zum Durchführen des vorgängig beschriebenen Verfahrens. Die Vorrichtung umfasst eine Applizier-Einheit zum Aufbringen von mit Öffnungen versehenem Isolationsmaterial auf die Solarzellen und eine Präge- oder Tiefzieheinheit mit wenigstens einem Prägestempel zum Schaffen von an die Öffnung angepassten Vertiefungen in aus Metallbändern geformten Kontaktelementen.

Ein jeweiliges Kontaktelement kann mehrere Vertiefungen aufweisen. Damit die Vertiefungen in einem Arbeitsgang geschaffen werden können, kann es vorteilhaft sein, wenn die Präge- oder Tiefzieheinheit eine Mehrzahl von Prägestempel aufweist. Selbstverständlich wäre es aber auch denkbar, die Vertiefungen mit einem einzigen Prägestempel je Kontaktelement aufzubringen.

Der oder die Prägestempel können als noppenartige Erhebungen ausgebildet sein, wodurch sich besonders einfach napfartige Vertiefungen in ein Metallband eingebracht werden können.

Weitere Einzelmerkmale und Vorteile der Erfindung ergeben sich aus der nachfolgenden Beschreibung eines Ausführungsbeispiels und aus den Zeichnungen. Es zeigen:
- Figur 1:: eine Draufsicht auf einen Solarzellen-String gemäss dem Stand der Technik,
- Figur 2:: eine vergrösserte Darstellung eines Kontakts zwischen Solarzelle und Kontaktelement des Solarzellen-Strings aus Figur 1, und
- Figur 3:: eine vergrösserte Darstellung eines Kontakts zwischen Solarzelle und Kontaktelement eines erfindungsgemässen Solarzellen-Strings.

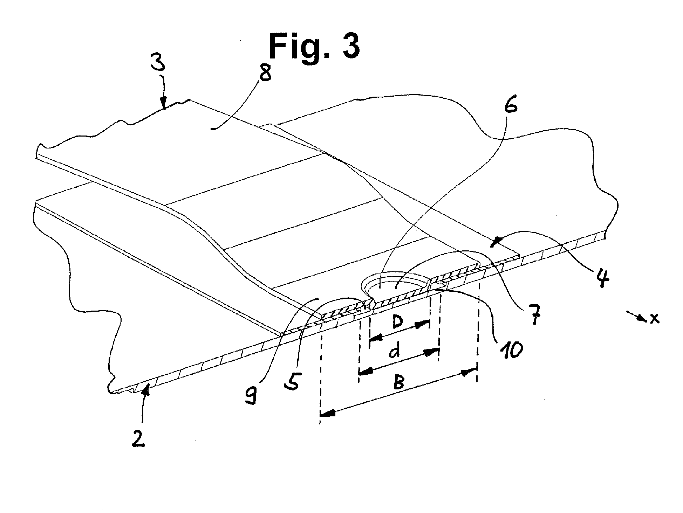

Figur 3 zeigt einen Kontakt zwischen Solarzelle 2 und Kontaktelement 3 eines erfindungsgemässen Solarzellen-Strings. Bis auf die nachfolgend im Detail beschriebenen, speziell ausgestalteten Kontaktelementen ist der Solarzellen-String in etwa gleichartig wie derjenige aus Figur 1 aufgebaut. Mittels derartiger Kontaktelemente 3 werden Rückseiten-Solarzellen 2 elektrisch verbunden. Das Kontaktelement 3, das aus einem Metallband hergestellt wird, verbindet jeweils einen oder mehrere n-dotierte Bereiche (-Pole) einer Solarzellen mit einem oder mehreren p-dotierten Bereiche (+Pole). Wie Figur 3 zeigt, ist auf der Solarzelle 2 im Bereich des n-Pols das an sich bekannte, sich in Längsrichtung x erstreckende Isolationsband 4 angeordnet (vgl. Figur 2). Das Isolationsband besteht im Wesentlichen aus einem elektrisch nicht oder nur schwach leitfähigen Material, beispielsweise aus einem flexiblen Kunststoffmaterial. Das Isolationsmaterial kann als Klebeband ausgestaltet sein, so dass es sich besonders einfach und in einem einzigen Arbeitsschritt (durch Andrücken) auf die Solarzellen aufbringen lässt. Derartige Isolationsbänder sind günstig und in unterschiedlichen Breiten, Dicken und Zusammensetzungen erhältlich und an den jeweiligen Einsatzzweck optimal anpassbar. Das Isolationsband 4 weist wenigstens eine Öffnung 5 auf, über die das Kontaktelement 3 die Solarzelle 2 in der n-dotierten Kontaktzone kontaktiert. Die Öffnung 5 ermöglicht ein Freilegen der mit 10 bezeichneten Kontaktzone ("n-Pad"), wodurch eine Kontaktierung der Solarzelle 2 durch das Kontaktelement 3 ermöglicht wird.

Zur Erstellung des Kontakts zur jeweiligen n-dotierten Kontaktzone 10 weist das Kontaktelement 3 eine napfartige Vertiefung 6 auf, die auf einfache Weise durch einen Tiefzieh - oder Prägevorgang beispielsweise unter Verwendung eines Prägestempels geschaffen werden kann. Das Kontaktelement 3 wird aus einem Metallband mit einer Breite B gefertigt, das zugeschnitten und durch Abkantprozesse oder ein anderes Umformverfahren vorgeformt wird. Durch diese Formgebung werden Zugentlastungsstrukturen geschaffen. Diese Zugentlastungsstrukturen können eine beim Fertigstellen des Kontaktes mittels z.B. Löten oder Schweissen auftretende unerwünschte, thermisch beeinflusste Ausdehnung oder Durchbiegung der Solarzellen verhindern oder zumindest reduzieren. Für die Kontaktelemente können beispielsweise Kupferbänder verwendet werden, die verzinnt (mit Lot beschichtet) oder versilbert sind. Es sind aber auch andere Materialien (wie etwa Aluminium) vorstellbar. Das Tiefziehen oder Prägen zum Schaffen der Vertiefungen kann vor, während oder nach dem Schaffen der Zugentlastungsstrukturen erfolgen. In der Regel weist jedes, jeweils einer Solarzelle zugeordnete Isolationsband mehrere Öffnungen auf, wobei jeder Öffnung eine n-dotierte Kontaktzone zugeordnet ist. Dementsprechend weist auch das zugehörige Kontaktelement allerdings mehrere, der Anzahl Öffnungen entsprechende Vertiefungen 6 auf. Etwa analog zur in Figur 1 gezeigten Gesamtanordnung kann der Solarzellenstring je Solarzelle mehrere, parallel zueinander verlaufende Kontaktelemente aufweisen. Beispielhaft kann der Solarzellen-String drei in Längsrichtung verlaufende Kontaktreihen mit paarweise angeordneten Kontaktelementen aufweisen. Jedes der drei Kontaktelement-Paare umfasst dabei zwei Kontaktelemente, die entsprechend dem alternierenden Anbringen des Isolationsmaterials umgekehrt orientiert sind (vgl. Fig. 1).

Die Vertiefung 6 weist zum Schaffen einer elektrisch vorteilhaften Kontaktfläche einen planen Napfboden 7 auf. Sowohl die Öffnung 5 als auch die der Öffnung zugeordnete Vertiefung 6 sind in Bezug auf die Draufsicht kreisförmig ausgestaltet. Der Napfdurchmesser D ist etwas kleiner als der Öffnungsdurchmesser d, so dass einerseits ein einfaches Einsetzen der Vertiefung in die Öffnung und ein sicheres elektrisches Verbinden (z.B. mittels Löten, Kleben, und/oder Schweissen) sichergestellt ist. Im Gegensatz zur bekannten, in Figur 2 gezeigten Lösung ist das hier gezeigte Kontaktelement 3 breiter als die Öffnung 5 im Isolationsmaterial 4, womit die Übertragungsleistung der Solarzellenverbindungen erheblich verbessert werden kann. Das Kontaktelement 3 überlappt mit anderen Worten die Öffnung 5. Der Durchmesser der Öffnung 5 ist mit d bezeichnet. Die Breite des Kontaktelements kann dank der tiefgezogenen oder eingeprägten Kontaktabschnitten somit von der Breite des n-Pads entkoppelt werden, wodurch sich die Gestaltungsmöglichkeiten und Freiheiten zur Auslegung und Dimensionierung der Kontaktelemente erweitern. Im vorliegenden Beispiel sind die Kontaktelemente 3 etwa doppelt so breit wie der Durchmesser d der Öffnungen 5. Sehr gute Ergebnisse lassen sich aber schon erzielen, wenn die Kontaktelemente gegenüber dem Durchmesser der Öffnungen 5 mindestens 25 % breiter sind. Dadurch ist es beispielsweise möglich, mit einem 4 oder 5 mm breiten Kontaktelement 4, was einen hohen Modulwirkungsgrad bewirkt, ein 2 mm breites n-Pad 10, was einen hohen Zellwirkungsgrad bewirkt, zu kontaktieren. Folglich können sowohl der Zellwirkungsgrad als auch der Modulwirkungsgrad maximiert werden. Das Kontaktelement 3 weist im Bereich jeder Vertiefung 6 je einen Flächenabschnitt 9 auf, der auf dem Isolationsmaterial 4 liegt. Die Tiefe der Vertiefung entspricht somit der Dicke des bandförmigen Isolationsmaterials 4. Die Flächenabschnitte 9 sind über freiliegende, von der Solarzelle beabstandeten Brückenabschnitte 8 verbunden.

In vorrichtungsmässiger Hinsicht zeichnet sich die Erfindung dadurch aus, dass sie eine (nicht dargestellte) Präge- oder Tiefzieheinheit aufweist, mit der Vertiefungen in aus Metallbändern bestehenden Kontaktelementen eingebracht werden können. Die Vorrichtung kann weiter eine Applizier-Einheit zum Aufbringen von vorzugsweise als Isolationsband vorliegendem Isolationsmaterial auf die Solarzellen umfassen. Das Isolationsband kann schon mit Öffnungen versehen sein, die in einem Vorfabrikationsprozess erstellt werden. Es ist aber auch vorstellbar, dass die vorgängig erwähnte Vorrichtung Mittel zum Schaffen von Öffnungen (z.B. eine Lochstation) in das Isolationsband umfasst. Die mit Kontaktelementen bestückten Solarzellen können eine (nicht dargestellte) Lötstation mit einer Vorheizzone passieren, in welcher die Kontaktierungen fertig gestellt werden. Der Lötstation kann ein Kühlbereich nachgelagert sein.

## Patentansprüche

1. Solarzellen-String mit mehreren entlang einer Längsrichtung (x) aneinander gereihten Solarzellen (2), insbesondere Rückseiten-Solarzellen, Kontaktelementen (3) zum elektrischen Verbinden der Solarzellen, wobei jedes Kontaktelement (3) ein Metallband ist und jeweils zwei benachbarte Solarzellen (2) miteinander verbindet, wobei in Bezug auf jeweils ein Kontaktelement (3) wenigstens eine der benachbarten Solarzellen (2) mit Isolationsmaterial (4) versehen ist, wobei das Isolationsmaterial (4) wenigstens eine Öffnung (5) aufweist, über die das Kontaktelement (3, 3') die Solarzellen (2) kontaktiert, **dadurch gekennzeichnet, dass** zum Erstellen des Kontakts zwischen Kontaktelement (3) und Solarzelle (2) das Kontaktelement (3) eine in der wenigstens einen Öffnung (5) aufgenommene Vertiefung (6) aufweist.

2. Solarzellen-String nach Anspruch 1, **dadurch gekennzeichnet, dass** die Vertiefung (6) eine vorzugsweise durch einen Tiefzieh- oder Prägevorgang geschaffene napfartige Vertiefung (6) ist.

3. Solarzellen-String nach Anspruch 1 oder 2, **dadurch gekennzeichnet, dass** die Vertiefung (6) zum Schaffen einer Kontaktfläche einen planen Napfboden (7) aufweist.

4. Solarzellen-String nach Anspruch 3, **dadurch gekennzeichnet, dass** die wenigstens eine Öffnung (5) und/oder die der Öffnung zugeordnete Vertiefung (6) kreisförmig oder oval ausgestaltet ist oder sind.

5. Solarzellen-String nach einem der Ansprüche 1 bis 4, **dadurch gekennzeichnet, dass** das Kontaktelement (3) in Bezug auf die Draufsicht die wenigstens eine Öffnung (5) allseitig überlappt.

6. Solarzellen-String nach Anspruch 6, **dadurch gekennzeichnet, dass** das Kontaktelement (3, 3') gegenüber dem Durchmesser (d) der wenigstens einen Öffnung (5) mindestens 25 %, bevorzugt mindestens 50 % und besonders bevorzugt etwa 100 % breiter ist.

7. Solarzellen-String nach einem der Ansprüche 1 bis 6, **dadurch gekennzeichnet, dass** das Kontaktelement (3) im Bereich einer Vertiefung (6) wenigstens einen Flächenabschnitt (9) aufweist, der auf dem Isolationsmaterial (4) liegt.

8. Solarzellen-String nach Anspruch 7, **dadurch gekennzeichnet, dass** das Kontaktelement (3) wenigstens zwei Flächenabschnitte (9) aufweist, die über einen freiliegenden Brückenabschnitt (8) verbunden sind.

9. Solarzellen-String nach einem der Ansprüche 1 bis 6, **dadurch gekennzeichnet, dass** die Vertiefung (6) eine Tiefe aufweist, die etwa der Dicke des Isolationsmaterials (4) entspricht oder die grösser als Dicke des Isolationsmaterials (4) ist.

10. Verfahren zum Verbinden von Solarzellen (2) und insbesondere von Rückseiten-Solarzellen zu einem Solarzellen-String, insbesondere einem Solarzellen-String gemäss einem der Ansprüche 1 bis 9, enthaltend folgende Schritte:
- wenigstens bereichsweises Aufbringen von mit Öffnungen (5) versehenen Isolationsmaterial (4) auf die Solarzellen (2),
- Einbringen von Vertiefungen (6) in aus Metallbändern hergestellten Kontaktelementen (3, 3') durch einen Tiefzieh- oder Prägevorgang,
- Bestücken der Solarzellen mit den Kontaktelementen (3) zum Erstellen einer elektrischen Verbindung zwischen den Solarzellen, wobei die Vertiefungen (6) in die Öffnungen (5) eingesetzt werden.

11. Vorrichtung zum elektrischen Verbinden von Solarzellen (2) mittels Kontaktelementen (3) und insbesondere zum elektrischen Verbinden von Rückseiten-Solarzellen zu einem Solarzellen-String, insbesondere zum Durchführen des Verfahrens gemäss einem der Ansprüche 1 bis 10, enthaltend
- eine Applizier-Einheit zum Aufbringen von mit Öffnungen (5) versehenen Isolationsmaterial (4) auf die Solarzellen (2),
- eine Präge- oder Tiefzieheinheit mit wenigstens einem Prägestempel zum Schaffen von an die Öffnungen angepassten Vertiefungen (6) in aus Metallbändern geformten Kontaktelementen (3).

12. Vorrichtung nach Anspruch 11, **dadurch gekennzeichnet, dass** die Präge- oder Tiefzieheinheit eine Mehrzahl von Prägestempel aufweist.

13. Vorrichtung nach Anspruch 12, **dadurch gekennzeichnet, dass** der oder die Prägestempel als noppenartige Erhebungen ausgebildet sind.
